(19) Europäisches Patentamt
European Patent Office
Office européen des brevets

(11) **EP 4 518 156 A1**

(12) **EUROPEAN PATENT APPLICATION**
published in accordance with Art. 153(4) EPC

(43) Date of publication:
**05.03.2025 Bulletin 2025/10**

(51) International Patent Classification (IPC):
**H03H 9/02** (2006.01)

(21) Application number: **23830051.1**

(52) Cooperative Patent Classification (CPC):
**H03H 9/02; H03H 9/64**

(22) Date of filing: **20.06.2023**

(86) International application number:
**PCT/CN2023/101384**

(87) International publication number:
**WO 2024/001872 (04.01.2024 Gazette 2024/01)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **30.06.2022 CN 202210771296**

(71) Applicants:
• **Huawei Technologies Co., Ltd.
Shenzhen, Guangdong 518129 (CN)**
• **Shanghai Jiao Tong University
Shanghai 200240 (CN)**

(72) Inventors:
• **LI, Zilin
Shanghai 200240 (CN)**
• **HAN, Tao
Shanghai 200240 (CN)**
• **LUAN, Zhongzhi
Shenzhen, Guangdong 518129 (CN)**
• **KE, Han
Shenzhen, Guangdong 518129 (CN)**
• **TAO, Xiang
Shenzhen, Guangdong 518129 (CN)**
• **JIANG, Xin
Shenzhen, Guangdong 518129 (CN)**

(74) Representative: **Körber, Martin Hans
Mitscherlich PartmbB
Patent- und Rechtsanwälte
Karlstraße 7
80333 München (DE)**

(54) **SURFACE ACOUSTIC WAVE FILTER, APPARATUS, AND ELECTRONIC DEVICE**

(57) Embodiments of this application provide a surface acoustic wave filter, an apparatus, and an electronic device. The surface acoustic wave filter includes a support substrate, a first acoustic velocity layer is disposed above the support substrate, a material of the first acoustic velocity layer is silicon dioxide, a piezoelectric layer is disposed above the first acoustic velocity layer, Euler angles of a cut of the piezoelectric layer are (-5° to 5°, 81° to 83°, 85° to 95°), and an interdigital electrode is disposed above the piezoelectric layer. A second acoustic velocity layer may be further included between the first acoustic velocity layer and the support substrate; and a material of the second acoustic velocity layer is aluminum nitride or silicon nitride, where a longitudinal wave acoustic velocity in the first acoustic velocity layer is lower than a longitudinal wave acoustic velocity in the piezoelectric layer, and a longitudinal wave acoustic velocity in the second acoustic velocity layer is higher than the longitudinal wave acoustic velocity in the piezoelectric layer. According to the surface acoustic wave filter provided in embodiments of this application, leakage of energy of a surface acoustic wave can be suppressed, and spurious modes can be reduced.

FIG. 2

# EP 4 518 156 A1

## Description

This application claims priority to Chinese Patent Application No. 202210771296.1, filed with the China National Intellectual Property Administration on June 30, 2022 and entitled "SURFACE ACOUSTIC WAVE FILTER, APPARATUS, AND ELECTRONIC DEVICE", which is incorporated herein by reference in its entirety.

## TECHNICAL FIELD

Embodiments of this application relate to the field of electronic information technologies, and more specifically, to a surface acoustic wave filter, an apparatus, and an electronic device.

## BACKGROUND

A surface acoustic wave filter is an important part of a mobile communication device, and also has important application in the field of sensing, detection, and the like. In a background in which a 5th generation (5th generation, 5G) communication technology uses carrier frequencies on higher frequency bands to implement high-bandwidth and low-delay communication, a surface acoustic wave filter with a higher frequency and a greater quality factor is urgently needed in the industry.

Conventional surface acoustic wave filters are usually made based only on monocrystalline piezoelectric substrates, such as a piezoelectric substrate made of lithium niobate and a piezoelectric substrate made of lithium tantalate. These piezoelectric substrates have a low acoustic velocity, and an electrode width required for achieving a high frequency is close to a theoretical limit of a process line width, and cannot meet a requirement for manufacturing a highfrequency device. In addition, in a mode of high acoustic velocity, acoustic wave energy of some cuts of these piezoelectric substrates is likely to leak to the piezoelectric substrate. Consequently, a quality factor of the device decreases, and actual application is affected. Some existing surface acoustic wave filters with a layered structure have many spurious modes, and a complex spurious mode suppression means is required in application such as carrier aggregation. Therefore, there is an urgent need to develop a surface acoustic wave filter capable of suppressing energy leakage and

## SUMMARY

Embodiments of this application provide a surface acoustic wave filter, an apparatus, and an electronic device, to suppress leakage of energy of a surface acoustic wave and reduce spurious modes.

According to a first aspect, a surface acoustic wave filter is provided, including: a support substrate; a first acoustic velocity layer, where the first acoustic velocity layer is disposed on the support substrate, and a material of the first acoustic velocity layer is silicon dioxide; a piezoelectric layer, where the piezoelectric layer is disposed on the first acoustic velocity layer, Euler angles of a cut of the piezoelectric layer are (-5° to 5°, 81° to 83°, 85° to 95°), and a longitudinal wave acoustic velocity in the piezoelectric layer is higher than a longitudinal wave acoustic velocity in the first acoustic velocity layer; and an interdigital electrode, where the interdigital electrode is disposed above the piezoelectric layer.

In an embodiment provided in this application, the surface acoustic wave filter with a multi-layer structure is designed, and the first acoustic velocity layer with a low acoustic velocity is disposed on the support substrate with a high acoustic velocity, so that a large acoustic velocity difference can be formed below the piezoelectric layer, that is, between the support substrate and the first acoustic velocity layer, so as to reflect acoustic wave energy that is propagated downward, thereby suppressing leakage of acoustic wave energy in the surface acoustic wave filter. When ranges of Euler angles of the piezoelectric layer are (-5° to 5°, 81° to 83°, 85° to 95°), spurious modes in a device can be significantly reduced, thereby facilitating actual application of the device.

With reference to the first aspect, in some implementations of the first aspect, a material of the support substrate is silicon carbide or diamond.

In an embodiment provided in this application, when the material of the support substrate is silicon carbide or diamond, a high acoustic velocity can be implemented in the support substrate, and a large acoustic velocity difference may be formed between the support substrate and the first acoustic velocity layer, so as to reflect the acoustic wave energy that is propagated downward, thereby suppressing leakage of the acoustic wave energy in the surface acoustic wave filter.

With reference to the first aspect, in some implementations of the first aspect, a material of the piezoelectric layer is lithium niobate.

In an embodiment provided in this application, the lithium niobate can enable the surface acoustic wave filter to have a large electromechanical coupling coefficient, reduce a propagation loss of a surface acoustic wave, and have excellent piezoelectric performance.

With reference to the first aspect, in some implementations of the first aspect, a surface acoustic wave mode excited by the piezoelectric layer is a longitudinal leaky mode.

In an embodiment provided in this application, when the surface acoustic wave mode is the longitudinal leaky mode, the surface acoustic wave filter can achieve a high acoustic velocity, so that a high operating frequency can be achieved, and a high frequency requirement of the device is met.

With reference to the first aspect, in some implementations of the first aspect, a thickness of the first acoustic velocity layer is 5%λ to 20%λ, and λ is a wavelength of the surface acoustic wave filter.

In an embodiment provided in this application, when the thickness of the first acoustic velocity layer is 5%λ to 20%λ, energy of a surface acoustic wave can be suppressed from leaking to the support substrate across an interface between the first acoustic velocity layer and the support substrate. In addition, it is difficult to form a new plate wave mode in the first acoustic velocity layer within the thickness range, so that formation of spurious modes can be suppressed.

With reference to the first aspect, in some implementations of the first aspect, a thickness of the piezoelectric layer is 20%λ to 30%λ, and λ is the wavelength of the surface acoustic wave filter.

In an embodiment provided in this application, when the thickness of the piezoelectric layer is 20%λ to 30%λ, a proportion of electric fields distributed in the piezoelectric layer is high, efficiency in exciting a surface acoustic wave is high, and a quantity of spurious modes can be reduced.

With reference to the first aspect, in some implementations of the first aspect, a material of the interdigital electrode is aluminum or copper.

In an embodiment provided in this application, when aluminum or copper is used as an electrode material, the interdigital electrode has good conductivity, and the electrode has low reflectivity, so that a low loss characteristic of the surface acoustic wave filter can be implemented.

With reference to the first aspect, in some implementations of the first aspect, a thickness of the interdigital electrode is 5%λ to 10%λ, and λ is the wavelength of the surface acoustic wave filter.

In an embodiment provided in this application, when the thickness of the interdigital electrode is 5%λ to 10%λ, a sum of a resistance loss and an acoustic loss of the interdigital electrode is low.

With reference to the first aspect, in some implementations of the first aspect, a thickness of the support substrate is 500 μm to 1200 μm.

With reference to the first aspect, in some implementations of the first aspect, the wavelength of the surface acoustic wave filter is 1 μm to 4 μm.

According to a second aspect, a surface acoustic wave filter is provided, including: a support substrate; a first acoustic velocity layer, where a material of the first acoustic velocity layer is silicon dioxide; a second acoustic velocity layer, where the second acoustic velocity layer is disposed between the support substrate and the first acoustic velocity layer, and a material of the second acoustic velocity layer is aluminum nitride or silicon nitride; a piezoelectric layer, where the piezoelectric layer is disposed on the first acoustic velocity layer, and Euler angles of a cut of the piezoelectric layer are (-5° to 5°, 81° to 83°, 85° to 95°); and an interdigital electrode, where the interdigital electrode is disposed above the piezoelectric layer, where a longitudinal wave acoustic velocity in the first acoustic velocity layer is lower than a longitudinal wave acoustic velocity in the piezoelectric layer, and a longitudinal wave acoustic velocity in the second acoustic velocity layer is higher than the longitudinal wave acoustic velocity in the piezoelectric layer.

In an embodiment provided in this application, the surface acoustic wave filter with a multi-layer structure is designed, the second acoustic velocity layer with a high acoustic velocity is disposed on the support substrate, and the first acoustic velocity layer with a low acoustic velocity is disposed on the second acoustic velocity layer, so that a large acoustic velocity difference can be formed below the piezoelectric layer, so as to reflect acoustic wave energy that is propagated downward, thereby suppressing leakage of acoustic wave energy in the surface acoustic wave filter. When ranges of Euler angles of the piezoelectric layer are (-5° to 5°, 81° to 83°, 85° to 95°), spurious modes in a device can be significantly reduced, thereby facilitating actual application of the device.

With reference to the second aspect, in some implementations of the second aspect, a material of the support substrate is aluminum oxide.

In an embodiment provided in this application, when the material of the support substrate is aluminum oxide, spurious modes in the device can be reduced, thereby facilitating actual application of the device.

With reference to the second aspect, in some implementations of the second aspect, a surface acoustic wave mode excited by the piezoelectric layer is a longitudinal leaky mode.

In an embodiment provided in this application, when the surface acoustic wave mode is the longitudinal leaky mode, the surface acoustic wave filter can achieve a high acoustic velocity, so that a high operating frequency can be achieved, and a high frequency requirement of the device is met.

With reference to the second aspect, in some implementations of the second aspect, a thickness of the second acoustic velocity layer is 30%λ to 50%λ, and λ is a wavelength of the surface acoustic wave filter.

In an embodiment provided in this application, when the thickness of the second acoustic velocity layer is 30%λ to 50%λ, energy of a surface acoustic wave can be suppressed from leaking to the support substrate across the interface between the second acoustic velocity layer and the first acoustic velocity layer. In addition, it is difficult to form a new plate wave mode in the second acoustic velocity layer within the thickness range, so that formation of spurious modes can be suppressed.

With reference to the second aspect, in some implementations of the second aspect, a thickness of the first acoustic velocity layer is 5%$\lambda$ to 20%$\lambda$, and $\lambda$ is the wavelength of the surface acoustic wave filter.

In an embodiment provided in this application, when the thickness of the first acoustic velocity layer is 5%$\lambda$ to 20%$\lambda$, energy of a surface acoustic wave can be suppressed from leaking to the support substrate across the interface between the first acoustic velocity layer and the second acoustic velocity layer. In addition, it is difficult to form a new plate wave mode in the first acoustic velocity layer within the thickness range, so that formation of spurious modes can be suppressed.

With reference to the second aspect, in some implementations of the second aspect, a thickness of the piezoelectric layer is 20%$\lambda$ to 30%$\lambda$, and $\lambda$ is the wavelength of the surface acoustic wave filter.

In an embodiment provided in this application, when the thickness of the piezoelectric layer is 20%$\lambda$ to 30%$\lambda$, a proportion of electric fields distributed in the piezoelectric layer is high, efficiency in exciting a surface acoustic wave is high, and a quantity of spurious modes can be reduced.

With reference to the second aspect, in some implementations of the second aspect, a material of the interdigital electrode is aluminum or copper.

In an embodiment provided in this application, when aluminum or copper is used as an electrode material, the interdigital electrode has good conductivity, and the electrode has low reflectivity, so that a low loss characteristic of the surface acoustic wave filter can be implemented.

With reference to the second aspect, in some implementations of the second aspect, a thickness of the interdigital electrode is 5%$\lambda$ to 10%$\lambda$, and $\lambda$ is the wavelength of the surface acoustic wave filter.

In an embodiment provided in this application, when the thickness of the interdigital electrode is 5%$\lambda$ to 10%$\lambda$, a sum of a resistance loss and an acoustic loss of the interdigital electrode is low.

With reference to the second aspect, in some implementations of the second aspect, a thickness of the support substrate is 500 $\mu$m to 1200 $\mu$m.

With reference to the second aspect, in some implementations of the second aspect, the wavelength of the surface acoustic wave filter is 1 $\mu$m to 4 $\mu$m.

According to a third aspect, an apparatus is provided, including the surface acoustic wave filter according to any one of the first aspect or the possible implementations of the first aspect or the surface acoustic wave filter according to any one of the second aspect or the possible implementations of the first aspect, and at least one of the following elements: a radio frequency switch, an amplifier, and a duplexer, where the surface acoustic wave filter is coupled to at least one of the radio frequency switch, the amplifier, and the duplexer.

According to a fourth aspect, an electronic device is provided, including: a transceiver, configured to receive a downlink signal or send an uplink signal, where the transceiver includes the filter according to the fourth aspect, and the filter is configured to filter a to-be-sent uplink signal before the uplink signal is sent, or filter a received downlink signal after the downlink signal is received; and a processor, configured to perform signal processing on the signal, for example, perform coding and modulation on to-be-sent data to generate an uplink signal, or demodulate or decode a received downlink signal.

## BRIEF DESCRIPTION OF DRAWINGS

FIG. 1 is a diagram of a structure of a surface acoustic wave filter according to an embodiment of this application;

FIG. 2 is a diagram of a structure of a surface acoustic wave filter according to an embodiment of this application;

FIG. 3 is a diagram of transformation of a crystallographic coordinate system applicable to an embodiment of this application;

FIG. 4A, FIG. 4B, and FIG. 4C are admittance curve graphs corresponding to different Euler angles of a cut of a piezoelectric layer according to an embodiment of this application;

FIG. 5 is an admittance curve graph corresponding to a cut of a piezoelectric layer according to an embodiment of this application;

FIG. 6 is a diagram of a structure of a surface acoustic wave filter according to an embodiment of this application;

FIG. 7A and FIG. 7B are admittance curve graphs of different cuts of a piezoelectric layer according to an embodiment of this application;

FIG. 8A, FIG. 8B, and FIG. 8C are admittance curve graphs corresponding to different Euler angles of a cut of a piezoelectric layer according to an embodiment of this application;

FIG. 9A and FIG. 9B are admittance curve graphs of different cuts of a piezoelectric layer according to an embodiment of this application;

FIG. 10A, FIG. 10B, and FIG. 10C are admittance curve graphs corresponding to different Euler angles of a cut of a piezoelectric layer according to an embodiment of this application;

FIG. 11 is a diagram of a radio frequency module of a wireless communication device according to an embodiment of this application; and

FIG. 12 is a diagram of an electronic device according to an embodiment of this application.

## DESCRIPTION OF EMBODIMENTS

The following describes technical solutions of embodiments in this application with reference to accompanying drawings.

Reference to "an embodiment", "some embodiments", or the like described in this specification indicates that one or more embodiments of this application include a specific feature, structure, or characteristic described with reference to the embodiment. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner.

The terms "include", "have", and their variants all mean "include but are not limited to", unless otherwise specifically emphasized in another manner.

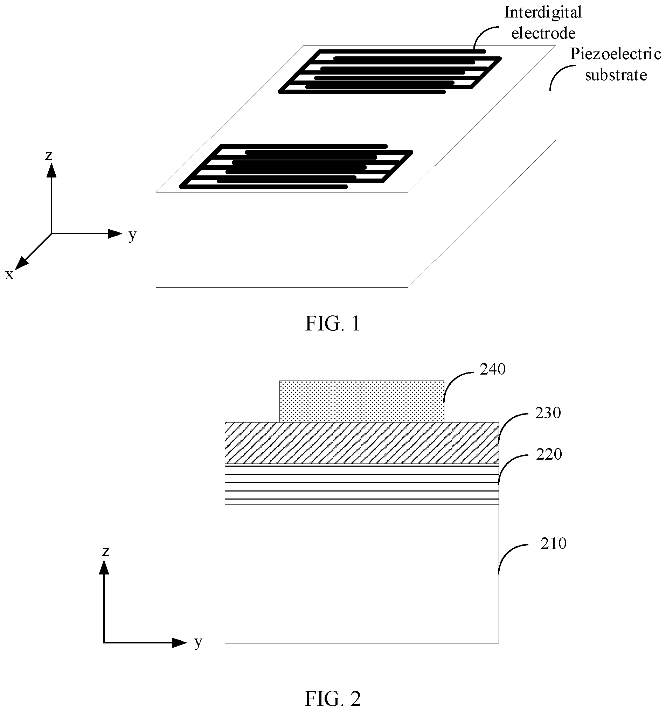

A surface acoustic wave is an elastic wave generated and propagated on a surface of a piezoelectric substrate, and an amplitude of the surface acoustic wave decreases as a depth in the piezoelectric substrate increases. FIG. 1 is a diagram of a structure of a surface acoustic wave filter according to an embodiment of this application. The surface acoustic wave filter includes an interdigital electrode (interdigital electrode, IDT) and a piezoelectric substrate. The interdigital electrode is disposed on the piezoelectric substrate, and forms a staggered interlocking comb-like structure. When an alternating electric field is applied to the interdigital electrode, because a voltage difference exists between adjacent electrode fingers, mechanical deformation occurs in a piezoelectric layer below the interdigital electrode, and a mechanical wave perpendicular to a direction of the electrode finger, that is, an x-axis direction, is generated. The mechanical wave may be propagated in two directions, that is, propagated along the x-axis direction and propagated along a z-axis direction. A wavelength λ of the surface acoustic wave filter is determined by a distance between electrode fingers of the interdigital electrode, that is, a distance between centers of electrode fingers that are connected to different potentials is λ/2.

Different boundary conditions and propagation medium conditions can stimulate different surface acoustic waves of different modes. The following describes several common types of surface acoustic waves.

(1) Rayleigh wave (Rayleigh wave): A Rayleigh wave has a surface normal component and a surface parallel component relative to a propagation direction. Energy of the Rayleigh wave is usually limited to being near a surface, and movement along a wave direction on a vertical plane is elliptic.

(2) Shear horizontal surface acoustic wave (shear horizontal surface acoustic wave, SH-SAW): For SH-SAW, a vibration direction of the wave is perpendicular to a propagation direction, which reduces an energy loss of the acoustic wave and limits the acoustic wave to a substrate surface, so that an SH-SAW sensor can operate efficiently in liquid and gas media.

(3) Love wave (Love wave): A layer of low acoustic velocity material is deposited on a substrate with an infinite thickness to stimulate a wave, so as to keep most of vibration energy close to a surface. These waves are transverse and therefore make only shear stress work.

(4) Surface transverse wave (surface transverse wave, STW): An STW sensor is a device that limits shear vibration to a surface of an interdigital electrode. A metal grating is inserted onto a delay line between electrodes, periodic disturbances are introduced in a propagation path of a wave, and a surface wave velocity is reduced. Because vibration energy density is concentrated on the metal grating near the surface, the device is very sensitive to surface disturbances and has high mass sensitivity.

(5) Longitudinal leaky surface acoustic wave (longitudinal leaky SAW, LL-SAW): A propagation direction of the LL-SAW is the same as a vibration direction, and the LL-SAW has a high acoustic velocity.

A velocity and a frequency of a surface acoustic wave are positively correlated, and a frequency f of the surface acoustic wave may be represented as:

$$f = v/\lambda,$$

where v is an acoustic velocity in a unit of m/s, and λ is a wavelength in a unit of m. A higher acoustic velocity indicates a higher frequency that can be achieved by a device. An operating frequency of a filter is related to an electrode width of an interdigital electrode: A narrower electrode width indicates a higher operating frequency. A common piezoelectric substrate, for example, a piezoelectric substrate made of lithium niobate ($LiNbO_3$, LN) or a piezoelectric substrate made of lithium tantalate ($LiTaO_3$, LT), usually has a low acoustic velocity, and an electrode width required for achieving a high frequency is close to a limit of a process line width, and cannot meet a requirement for manufacturing a high frequency surface acoustic wave filter. In addition, in a mode of high acoustic velocity, acoustic wave energy of some cuts of these piezoelectric substrates is likely to leak to the piezoelectric substrate. Consequently, a quality factor, that is, Q value, of the device decreases, and actual application is affected.

A longitudinal leaky surface acoustic wave mode with a high acoustic velocity and a large electromechanical coupling coefficient is used on the piezoelectric substrate, and a thin film and a support substrate that are of a proper thickness are designed, so that energy radiated to the support substrate can be guided into the piezoelectric thin film, thereby suppressing energy leakage and further increasing a Q value of the device. In the longitudinal leaky surface acoustic wave mode, the acoustic velocity is usually higher, the operating frequency is usually higher than that of an existing SH-SAW device when an electrode line width remains unchanged, and an electromechanical coupling coefficient of the device can be increased, so as to reduce energy leakage, and increase the Q value of the device.

Therefore, in this embodiment of this application, the longitudinal leaky surface acoustic wave is used, and a surface acoustic wave filter with a multi-layer film structure is provided, so that an acoustic velocity difference between layers is increased to suppress energy leakage, and a material or a thickness of a low acoustic velocity layer and a high acoustic velocity layer are adjusted to reduce spurious modes.

An electromechanical coupling coefficient is a degree of mutual conversion between energy that converts mechanical energy into electrical energy or converts electrical energy into mechanical energy in a vibration process of a piezoelectric oscillator. A larger electromechanical coupling coefficient indicates a greater degree of electromechanical conversion. A surface acoustic wave filter with a large electromechanical coupling coefficient can be applied to a broadband filter. The Q value is the quality factor, and is a measure of energy dissipation in the surface acoustic wave filter. A greater Q value indicates a lower energy dissipation rate.

FIG. 2 is a sectional view of a surface acoustic wave filter with a multi-layer structure according to an embodiment of this application. The structure may be obtained through cutting along a z-axis direction on any electrode finger of an interdigital electrode. As shown in FIG. 2, the surface acoustic wave filter includes a support substrate 210, a low acoustic velocity layer 220, a piezoelectric layer 230, and an interdigital electrode 240.

A. Support substrate 210

In some embodiments, for a filter that uses a longitudinal leaky surface acoustic wave mode, an acoustic velocity of the longitudinal leaky surface acoustic wave mode propagated in the piezoelectric layer is greater than 5500 m/s to 6000 m/s. A longitudinal wave acoustic velocity of the support substrate 210 usually needs to be higher than 6000 m/s, to achieve good effect of an energy wave guide. A large acoustic velocity difference may be formed between the support substrate 210 and the low acoustic velocity layer 220 by using a support substrate material with a high acoustic velocity, so as to suppress leakage of energy of a surface acoustic wave that is propagated downward.

In some embodiments, a material of the support substrate 210 may be silicon carbide SiC, and the SiC may be SiCs of different crystal types, such as 3C-SiC, 4H-SiC, and 6H-SiC. A transverse wave acoustic velocity of 3C-SiC is 8518 m/s, and a longitudinal wave acoustic velocity is 10476 m/s. A thickness of the support substrate 210 may be set to 500 $\mu$m to 1200 $\mu$m, depending on a wavelength of a device and a process requirement of a semiconductor.

The support substrate 210 may further support another layer structure of the surface acoustic wave filter.

B. Low acoustic velocity layer 220

The low acoustic velocity layer 220 is disposed above the support substrate 210. "Above" in this application may be understood as being above a z-axis direction as illustrated. The low acoustic velocity layer 220 may also be referred to as a first acoustic velocity layer. A longitudinal wave acoustic velocity in the low acoustic velocity layer 220 is less than a longitudinal wave acoustic velocity in the piezoelectric layer 230. The longitudinal wave acoustic velocity is a surface acoustic wave velocity whose propagation direction is the same as a vibration direction.

In some embodiments, a material of the low acoustic velocity layer 220 may be silicon dioxide $SiO_2$. The longitudinal wave acoustic velocity in the low acoustic velocity layer 220 is less than the longitudinal wave acoustic velocity in the piezoelectric layer 230. A large acoustic velocity difference can be formed between the low acoustic velocity layer 220 and the support substrate layer 210 by using the low acoustic velocity layer 220, to reflect acoustic wave energy propagated downward, so that energy is concentrated in the piezoelectric layer 230, and leakage of acoustic wave energy is suppressed. In addition, using $SiO_2$ to make the low acoustic velocity layer 210 can reduce an absolute value of a frequency temperature coefficient, thereby improving a temperature characteristic. The use of $SiO_2$ can also improve bonding quality of an LN layer and improve bonding strength thereof.

In some embodiments, a thickness of the low acoustic velocity layer 220 may be 5%λ to 20%λ, where λ is a wavelength of the surface acoustic wave filter. When the low acoustic velocity layer 220 is excessively thin, the surface acoustic wave is likely to leak to the support substrate 210 through an interface between the low acoustic velocity layer 220 and the support substrate 210. However, when the low acoustic velocity layer 220 is excessively thick, a new plate wave mode is formed in the low acoustic velocity layer 220, and a new spurious mode appears.

In an embodiment provided in this application, that the thickness of the low acoustic velocity layer 220 is 5%λ to 20%λ may include that the thickness of the low acoustic velocity layer 220 is [5%λ, 20%λ], [5%λ, 20%λ), (5%λ, 20%λ], or (5%λ, 20%λ), that is, the thickness of the low acoustic velocity layer 220 may be 5%λ, 20%λ, or any value between 5%λ and 20%λ. Alternatively, that the thickness of the low acoustic velocity layer 220 is 5%λ to 20%λ may include that the thickness of the low acoustic velocity layer 220 is 5%λ to 7.5%λ, 7.5%λ to 10%λ, 10%λ to 12.5%λ, 12.5%λ to 15%λ, 15%λ to 17.5%λ, 17.5%λ to 20%λ, or the like.

## C. Piezoelectric layer 230

In some embodiments, a material of the piezoelectric layer 230 may be lithium niobate LN, a thickness of the piezoelectric layer 230 may be 20%λ to 30%λ, and Euler angles of an LN cut may be (-5° to 5°, 81° to 83°, 85° to 95°).

In an embodiment provided in this application, that the thickness of the piezoelectric layer 230 is 20%λ to 30%λ may include that the thickness of the piezoelectric layer 230 is [20%λ, 30%λ], [20%λ, 30%λ), (20%λ, 30%λ], or (20%λ, 30%λ), that is, the thickness of the piezoelectric layer 230 may be 20%λ, 30%λ, or any value between 20%λ and 30%λ. Alternatively, that the thickness of the piezoelectric layer 230 is 20%λ to 30%λ may include that the thickness of the piezoelectric layer 230 is 20%λ to 22%λ, 22%λ to 24%λ, 24%λ to 26%λ, 26%λ to 28%λ, 28%λ to 30%λ, or the like.

In an embodiment provided in this application, Euler angles of the LN cut are (-5° to 5°, 81° to 83°, 85° to 95°). The first angle -5° to 5° may include [-5°, 5°], [-5°, 5°), (-5°, 5°], or (-5°, 5°), that is, the angle may be -5°, 5°, or any value between -5° and 5°. The first angle -5° to 5° may further include -5° to -3°, -3° to -1°, -1° to 1°, 1° to 3°, 3° to 5°, or the like. The second angle 81° to 83° may include [81°, 83°], [81°, 83°), (81°, 83°], or (81°, 83°), that is, the angle may be 81°, 83°, or any value between 81° and 83°. The second angle 81° to 83° may further include 81° to 81.5°, 81.5° to 82°, 82° to 82.5°, 82.5° to 83°, or the like. The third angle 85° to 95° may include [85°, 95°], [85°, 95°), (85°, 95°], or (85°, 95°), that is, the angle may be 85°, 95°, or any value between 85° and 95°. The third angle 85° to 95° may further include 85° to 87°, 87° to 89°, 89° to 91°, 91° to 93°, 93° to 95°, or the like.

The LN used in this embodiment of this application is a common material of a piezoelectric substrate, and has stable physical and chemical properties. In addition, the LN has a large electromechanical coupling coefficient, a low propagation loss, and excellent piezoelectric performance.

The LN cut can affect piezoelectric performance of an LN wafer and an acoustic velocity of a surface acoustic wave. For example, in the YZ or X-40Y cut, an excited surface acoustic wave mode is the longitudinal leaky wave mode; in the 128YX cut, the excited surface acoustic wave mode is the Rayleigh wave mode; and in the 41YX cut, the excited surface acoustic wave mode is the Love wave mode.

Euler angles of an LN cut provided in this application are (-5° to 5°, 81° to 83°, 85° to 95°), and a longitudinal leaky surface acoustic wave can be excited, to achieve a high acoustic velocity mode, thereby improving an operating frequency of the surface acoustic wave filter. In this cut, a thickness of the low acoustic velocity layer 220 is adjusted to reduce spurious modes.

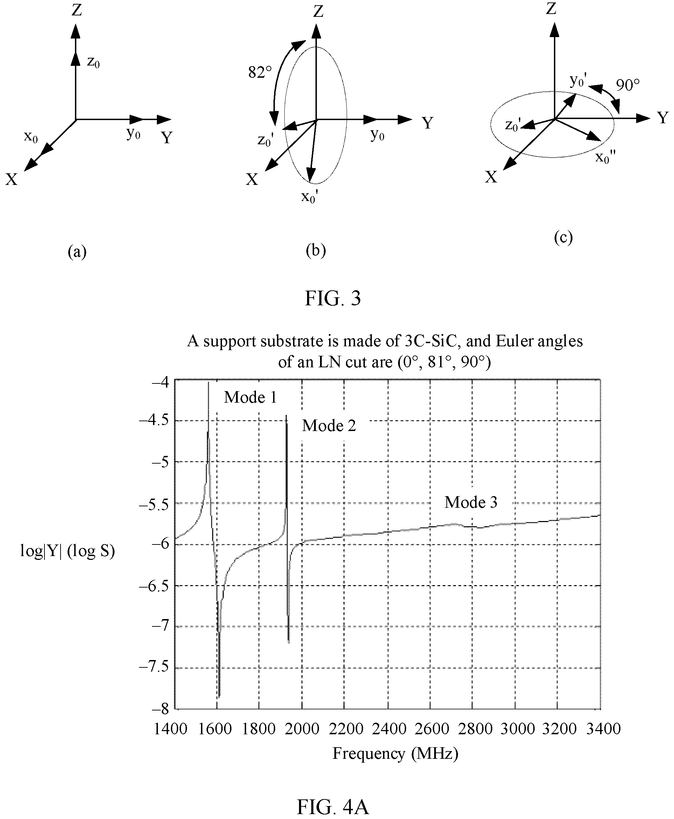

The Euler angles represent a conversion relationship from a crystallographic coordinate system to a current coordinate system, that is, cutting is performed by rotating a direction and an angle of a wafer, to obtain a wafer with a specific cutting direction and angle. For example, for Euler angles (0°, 82°, 90°), in the initial crystallographic coordinate system, the crystallographic coordinate system overlaps with a Cartesian coordinate system, as shown in (a) in FIG. 3. First, a z-axis of the crystallographic coordinate system is fixed, and the z-axis is rotated by 0° counterclockwise around the z-axis (equivalent to no rotation in this example). Then, an x-axis of the crystallographic coordinate system is fixed, and the x-axis is rotated by 82° counterclockwise around the x-axis to obtain a new coordinate system shown in (b) in FIG. 3, that is, $x_0'y_0z_0'$; and in this case, the z' axis is parallel to a normal direction of the wafer. Then, the $z_0'$ axis in the coordinate system shown in (b) in FIG. 3 is fixed, and the z0' axis is rotated by 90° counterclockwise around the $z_0'$ axis, to obtain a coordinate system $x_0''y_0'z_0'$ shown in (c) in FIG. 3; and in this case, the $x_0'$ axis is parallel to a propagation direction of a surface acoustic wave. A cutting plane of the wafer may be determined based on the Euler angles, so as to obtain an LN wafer required in this embodiment of this application.

## D. Interdigital electrode 240

In some embodiments, a material of the interdigital electrode 240 may be aluminum Al or copper Cu, and the interdigital electrode made of either Al or Cu has good conductivity and stable performance, and requires low costs. In addition, the electrode made of either Al or Cu has low reflectivity, so that a low loss characteristic of the surface acoustic wave filter can be implemented.

In some embodiments, a thickness of the interdigital electrode may be 5%λ to 10%λ, and within the thickness range, a sum of a resistance loss and an acoustic loss of the interdigital electrode is low.

In an embodiment provided in this application, that the thickness of the interdigital electrode 240 is 5%λ to 10%λ may include that the thickness of the interdigital electrode 240 is [5%λ, 10%λ], [5%λ, 10%λ), (5%λ, 10%λ], or (5%λ, 10%λ), that is, the thickness of the interdigital electrode 240 may be 5%λ, 10%λ, or any value between 5%λ and 10%λ. Alternatively, that the thickness of the interdigital electrode 240 is 5%λ to 10%λ may include that the thickness of the interdigital electrode 240 is 5%λ to 6%λ, 6%λ to 7%λ, 7%λ to 8%λ, 8%λ to 9%λ, 9%λ to 10%λ, or the like.

The foregoing surface acoustic wave filter can significantly reduce out-of-band spurious modes, that is, spurious modes outside an operating frequency band range of the surface acoustic wave filter. As an example, FIG. 4A is a corresponding admittance curve graph of the surface acoustic wave filter with the structure shown in FIG. 2 when Euler angles of an LN cut are (0°, 81°, 90°). A wavelength λ of the surface acoustic wave filter is 3.6 μm; a material of an interdigital electrode 240 is Cu, a thickness of the interdigital electrode 240 is 5%λ, and a duty cycle of the interdigital electrode 240 is 50%; a thickness of the piezoelectric layer 230 is 20%λ; a thickness of the low acoustic velocity layer 220 is 10%λ; and a material of the support substrate 210 is 3C-SiC, and a thickness of the support substrate 210 is 500 μm to 1200 μm. The duty cycle may be a ratio of an energized time to a total time in a pulse cycle, or the duty cycle may be a ratio of an electrode finger to a spacing between electrode fingers.

As shown in FIG. 4A, mode 1 is a primary mode, and a resonance frequency corresponding to mode 1 is 1559 MHz. The resonance frequency 1559 MHz is a positive resonance mode of mode 1, and mode 1 further includes an anti-resonance frequency, that is, 1608 MHz. A spurious mode, that is, mode 2, is included at a location higher than a frequency of mode 1. A positive resonance frequency corresponding to mode 2 is 1929 MHz. A frequency of mode 3 is far away from the frequency of mode 1. In addition, mode 3 is an extremely weak spurious mode, and impact on an operating frequency of the primary mode may be ignored. It can be seen from FIG. 4A that a quantity of spurious modes of the surface acoustic wave filter is significantly reduced. In actual application of the surface acoustic wave filter, only impact of mode 2 on the operating frequency of the primary mode needs to be eliminated.

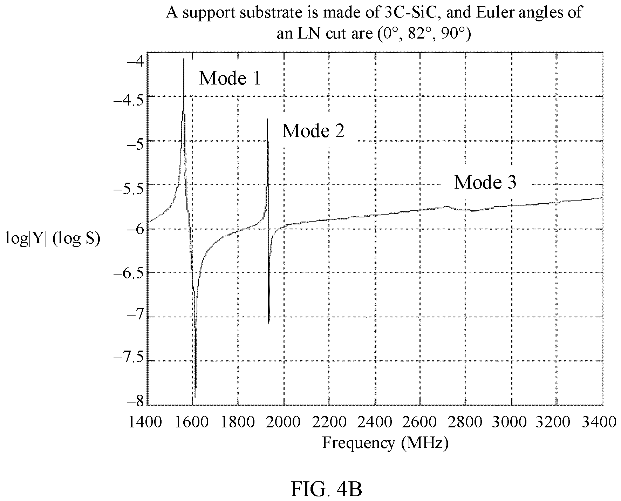

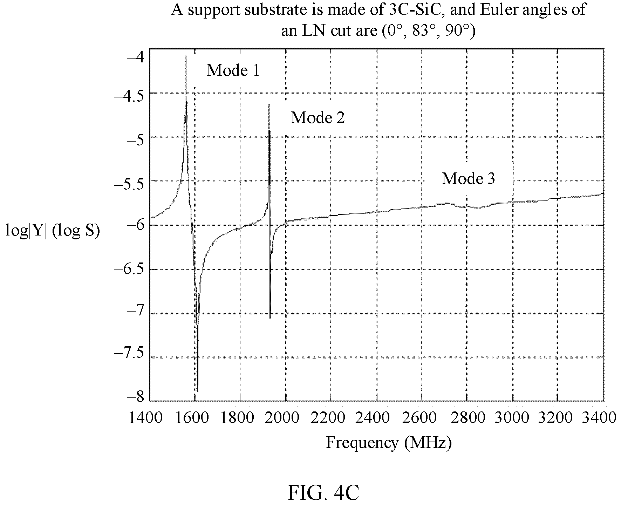

FIG. 4B and FIG. 4C are respectively corresponding admittance curve graphs of the surface acoustic wave filter with the structure shown in FIG. 2 when Euler angles of an LN cut are (0°, 82°, 90°) and (0°, 83°, 90°). A frequency position and strength of an acoustic wave mode are similar to those shown in FIG. 4A. Therefore, the cuts of the piezoelectric layer provided in this embodiment of this application can significantly reduce out-of-band spurious modes of the surface acoustic wave filter.

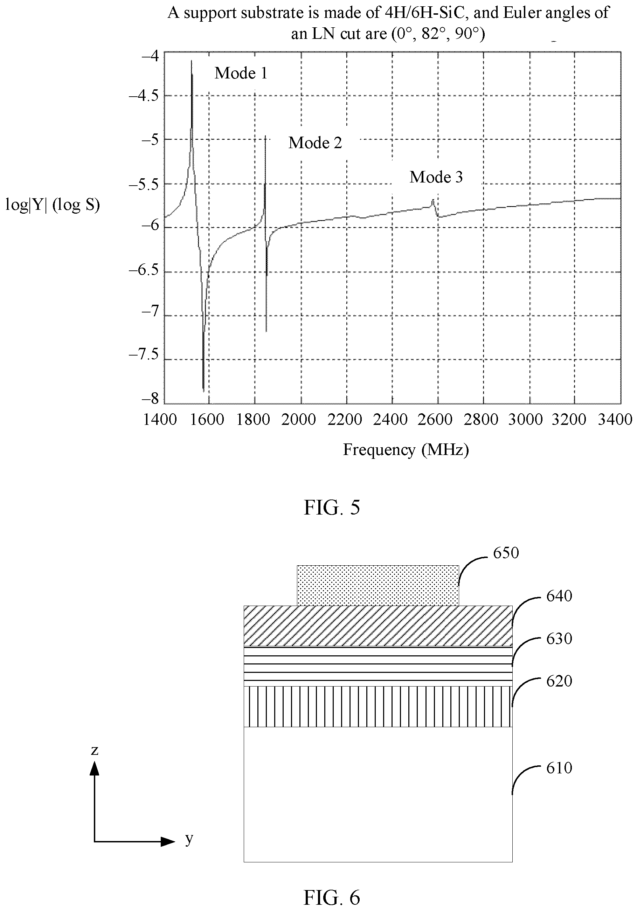

FIG. 5 shows a simulation result of a corresponding admittance curve of the surface acoustic wave filter with the structure shown in FIG. 2 when the support substrate is made of 4H/6H-SiC and the Euler angles of an LN cut are (0°, 82°, 90°). The simulation result is similar to a simulation result of an admittance curve when the support substrate is made of 3C-SiC. It can be seen that SiC materials of different crystal types have little impact on the spurious modes of the surface acoustic wave filter, and the out-of-band spurious modes of the surface acoustic wave filter can be significantly reduced when the support substrate is made of SiC materials of different crystal types.

FIG. 6 is a sectional view of another surface acoustic wave filter according to an embodiment of this application. The surface acoustic wave filter may further include a high acoustic velocity layer, configured to further suppress energy leakage, increase a Q value of a device, and reduce out-of-band spurious modes.

A. Support substrate 610

When the surface acoustic wave filter is a longitudinal leaky surface acoustic wave filter, a transverse wave spurious mode with an acoustic velocity greater than 7000 m/s above the longitudinal leaky surface acoustic wave mode is susceptible to impact of a waveguide. If a transverse wave acoustic velocity of a used support substrate material is greater than 7000 m/s, the waveguide also has impact on mode, and spurious modes occur in a frequency response of a device. Therefore, a support substrate whose longitudinal wave acoustic velocity is higher than 6000 m/s and whose transverse wave acoustic velocity is lower than 7000 m/s may be selected to adjust an acoustic velocity in the longitudinal leaky mode.

In some embodiments, a material of the support substrate 610 may be aluminum oxide $Al_2O_3$. A longitudinal wave acoustic velocity of $Al_2O_3$ is 11174 m/s, and a transverse wave acoustic velocity thereof is 6077 m/s. The longitudinal wave acoustic velocity value and the transverse wave acoustic velocity value are acoustic velocities that can be reached in pure $Al_2O_3$. A thickness of the support substrate 610 may be 500 μm to 1200 μm.

B. High acoustic velocity layer 620

The high acoustic velocity layer 620 is disposed above the support substrate 610, that is, located between the support substrate 610 and the low acoustic velocity layer 630. The high acoustic velocity layer 620 may also be referred to as a second acoustic velocity layer, and a longitudinal wave acoustic velocity in the high acoustic velocity layer 620 is greater than a longitudinal wave acoustic velocity in the piezoelectric layer 640. The low acoustic velocity layer 630 may alternatively be referred to as a first acoustic velocity layer, and the longitudinal wave acoustic velocity in the low acoustic velocity layer 630 is less than a longitudinal wave acoustic velocity in the piezoelectric layer 640.

In some embodiments, the high acoustic velocity layer 620 may be made of aluminum nitride AlN or silicon nitride $Si_3N_4$. The high acoustic velocity layer 620 made of either AlN or $Si_3N_4$ may achieve a high acoustic velocity, so that a large acoustic velocity difference can be formed between the high acoustic velocity layer 620 and the low acoustic velocity layer 630. Specifically, a longitudinal wave acoustic velocity of the high acoustic velocity layer 620 made of AlN is 10287 m/s, and a transverse wave acoustic velocity thereof is 6016 m/s; and a longitudinal wave acoustic velocity of the high acoustic velocity layer 620 made of $Si_3N_4$ is 10925 m/s, and a transverse wave acoustic velocity thereof is 5467 m/s.

In some embodiments, a thickness of the high acoustic velocity layer 620 may be 30%λ to 50%λ.

In an embodiment provided in this application, that the thickness of the high acoustic velocity layer 620 is 30%λ to 50%λ may include that the thickness of the high acoustic velocity layer 620 is [30%λ, 50%λ], [30%λ, 50%λ], (30%λ, 50%λ], or (30%λ, 50%λ), that is, the thickness of the high acoustic velocity layer 620 may be 30%λ, 50%λ, or any value between 30%λ and 50%λ. Alternatively, that the thickness of the high acoustic velocity layer 620 is 30%λ to 50%λ may include that the thickness of the high acoustic velocity layer 620 is 30%λ to 32%λ, 32%λ to 34%λ, 34%λ to 36%λ, 36%λ to 38%λ, 38%λ to 40%λ, 40%λ to 42%λ, 42%λ to 44%λ, 44%λ to 46%λ, 46%λ to 48%λ, 48%λ to 50%λ, or the like.

### C. Low acoustic velocity layer 630

In some embodiments, the low acoustic velocity layer 630 is disposed above the high acoustic velocity layer 620, and the low acoustic velocity layer 630 may be made of $SiO_2$.

The high acoustic velocity layer 620 and the low acoustic velocity layer 630 are disposed, and an acoustic velocity difference between the high acoustic velocity layer 620 and the low acoustic velocity layer 630 is greater than an acoustic velocity difference between the low acoustic velocity layer 630 and the support substrate 610. Therefore, a larger acoustic velocity difference may be formed between the high acoustic velocity layer 620 and the low acoustic velocity layer 630, thereby improving reflection of acoustic wave energy, improving suppression of energy leakage, and increasing a quality factor of a device.

In some embodiments, a thickness of the low acoustic velocity layer 630 may be 5%λ to 20%λ.

In an embodiment provided in this application, that the thickness of the low acoustic velocity layer 630 is 5%λ to 20%λ may include that the thickness of the low acoustic velocity layer 630 is [5%λ, 20%λ], [5%λ, 20%λ), (5%λ, 20%λ], or (5%λ, 20%λ), that is, the thickness of the low acoustic velocity layer 630 may be 5%λ, 20%λ, or any value between 5%λ and 20%λ. Alternatively, that the thickness of the low acoustic velocity layer 630 is 5%λ to 20%λ may include that the thickness of the low acoustic velocity layer 630 is 5%λ to 7.5%λ, 7.5%λ to 10%λ, 10%λ to 12.5%λ, 12.5%λ to 15%λ, 15%λ to 17.5%λ, 17.5%λ to 20%λ, or the like.

When the low acoustic velocity layer 630 is excessively thin, the surface acoustic wave is likely to leak to the lower layer through an interface between the low acoustic velocity layer 630 and the high acoustic velocity layer 620. When the low acoustic velocity layer 630 is excessively thick, a new plate wave mode is formed in the low acoustic velocity layer 630, and a new spurious mode appears.

In addition, using $SiO_2$ to make the low acoustic velocity layer 630 can reduce an absolute value of a frequency temperature coefficient, thereby improving a temperature characteristic. The use of $SiO_2$ can also improve bonding quality of an LN layer and improve bonding strength thereof.

### D. Piezoelectric layer 640

The piezoelectric layer 640 is disposed above the low acoustic velocity layer 630, and the piezoelectric layer 640 may be made of LN. Similarly, Euler angles of an LN cut are (-5° to 5°, 81° to 83°, 85° to 95°), and a thickness of the piezoelectric layer may be 5%λ to 10%λ.

In an embodiment provided in this application, that the thickness of the piezoelectric layer 640 is 20%λ to 30%λ may include that the thickness of the piezoelectric layer 640 is [20%λ, 30%λ], [20%λ, 30%λ), (20%λ, 30%λ], or (20%λ, 30%λ), that is, the thickness of the piezoelectric layer 640 may be 20%λ, 30%λ, or any value between 20%λ and 30%λ. In addition, that the thickness of the piezoelectric layer 640 is 20%λ to 30%λ may further include that the thickness of the piezoelectric layer 640 is 20%λ to 22%λ, 22%λ to 24%λ, 24%λ to 26%λ, 26%λ to 28%λ, 28%λ to 30%λ, or the like.

In an embodiment provided in this application, Euler angles of an LN cut are (-5° to 5°, 81° to 83°, 85° to 95°). The first angle -5° to 5° may include [-5°, 5°], [-5°, 5°), (-5°, 5°], or (-5°, 5°), that is, the angle may be -5°, 5°, or any value between -5° and 5°. The first angle -5° to 5° may further include -5° to -3°, -3° to -1°, -1° to 1°, 1° to 3°, 3° to 5°, or the like. The second angle 81° to 83° may include [81°, 83°], [81°, 83°), (81°, 83°], or (81°, 83°), that is, the angle may be 81°, 83°, or any value between 81° and 83°. The second angle 81° to 83° may further include 81° to 81.5°, 81.5° to 82°, 82° to 82.5°, 82.5° to 83°, or the like. The third angle 85° to 95° may include [85°, 95°], [85°, 95°), (85°, 95°], or (85°, 95°), that is, the angle may be 85°, 95°, or any value between 85° and 95°. The third angle 85° to 95° may further include 85° to 87°, 87° to 89°, 89° to 91°, 91° to 93°, 93° to 95°, or the like.

E. Interdigital electrode 650

The interdigital electrode 650 is disposed above the piezoelectric layer 640, the interdigital electrode 650 may be made of Al or Cu, and a thickness of the interdigital electrode 650 may be 5%$\lambda$ to 10%$\lambda$.

In an embodiment provided in this application, that the thickness of the interdigital electrode 650 is 5%$\lambda$ to 10%$\lambda$ may include that the thickness of the interdigital electrode 650 is [5%$\lambda$, 10%$\lambda$], [5%$\lambda$, 10%$\lambda$), (5%$\lambda$, 10%$\lambda$], or (5%$\lambda$, 10%$\lambda$), that is, the thickness of the interdigital electrode 650 may be 5%$\lambda$, 10%$\lambda$, or any value between 5%$\lambda$ and 10%$\lambda$. Alternatively, that the thickness of the interdigital electrode 650 is 5%$\lambda$ to 10%$\lambda$ may include that the thickness of the interdigital electrode 650 is 5%$\lambda$ to 6%$\lambda$, 6%$\lambda$ to 7%$\lambda$, 7%$\lambda$ to 8%$\lambda$, 8%$\lambda$ to 9%$\lambda$, 9%$\lambda$ to 10%$\lambda$, or the like.

When the Euler angles of an LN cut of the surface acoustic wave filter with the structure shown in FIG. 6 are (0°, 82°, 90°), a corresponding electromechanical coupling coefficient $k^2$ of the surface acoustic wave filter is 7.65%, a high electromechanical coupling coefficient can be reached, and a proportion of surface energy of the surface acoustic wave filter reaches 99.43%, so that an energy leakage problem is effectively resolved.

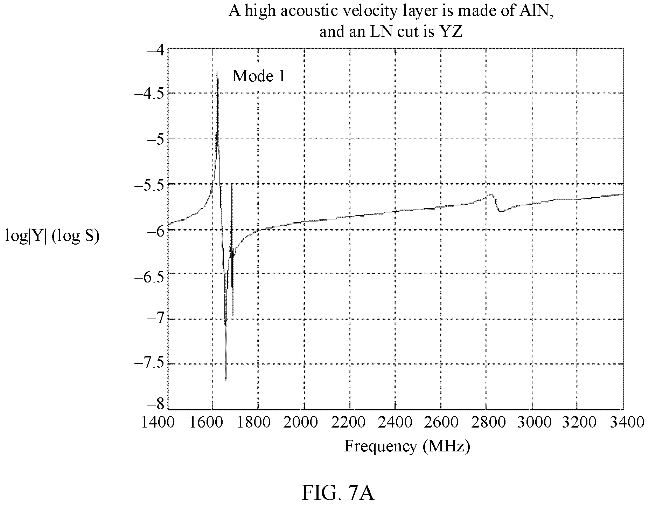

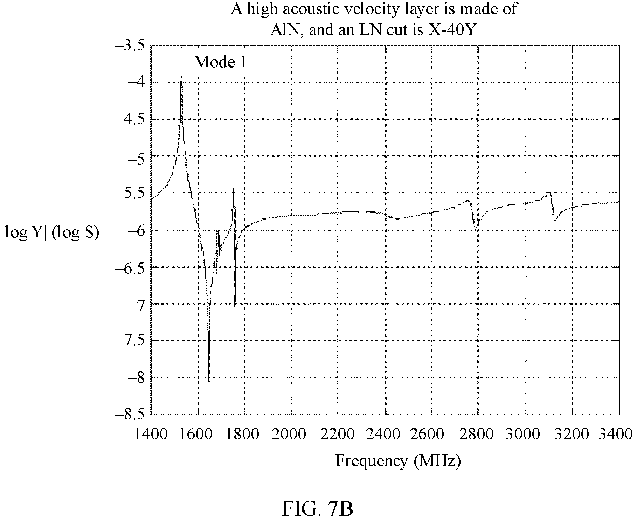

FIG. 7A and FIG. 7B are respectively admittance curve graphs of the surface acoustic wave filter with the structure shown in FIG. 6 when LN cuts are YZ and X-40Y, and a corresponding material of a high acoustic velocity layer is AlN. A wavelength $\lambda$ of the surface acoustic wave filter is 3.6 $\mu$m; a material of an interdigital electrode is Cu, a thickness of the interdigital electrode is 5%$\lambda$, and a duty cycle of the interdigital electrode is 50%; a thickness of the piezoelectric layer is 20%$\lambda$; a thickness of the high acoustic velocity layer is 50%$\lambda$; a thickness of the low acoustic velocity layer is 5%$\lambda$; and a material of the support substrate is $Al_2O_3$, and a thickness of the support substrate is 500 $\mu$m to 1200 $\mu$m.

As shown in FIG. 7A and FIG. 7B, when an LN cut is YZ or X-40Y, an obvious spurious mode exists at a location higher than a frequency of the primary mode, that is, higher than mode 1, in the admittance curves. For example, in FIG. 7A, a frequency ranges from 1650 MHz to 1700 MHz. Especially, in the X-40Y cut, there are a large quantity of spurious modes. For example, a frequency in FIG. 7B ranges from 1650 MHz to 1800 MHz. The device needs a complex spurious mode suppression means in practical use, which causes a waste of resources.

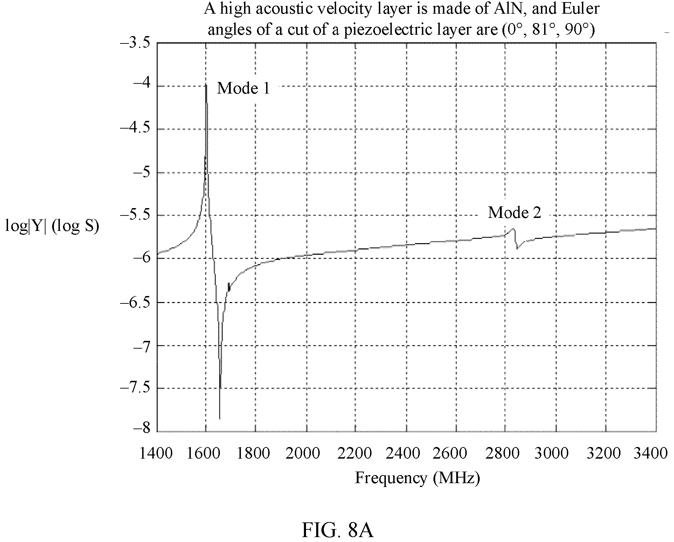

When the Euler angles of an LN cut of the surface acoustic wave filter are (0°, 81°, 90°), as shown in FIG. 8A, mode 1 is a primary mode, a resonance frequency of mode 1 is 1603 MHz, and mode 1 further includes an anti-resonance frequency, that is, 1659 MHz. Only one spurious mode, that is, mode 2, is included at a location higher than a frequency of mode 1, and mode 2 is an extremely weak spurious mode. A resonance frequency of mode 2 is 2832 MHz, which is higher than an upper limit of 2700 MHz in a practical frequency band. There is no visible spurious mode on the operating frequency band except for tiny oscillations above anti-resonance, and therefore actual operation of the surface acoustic wave filter is not easily affected.

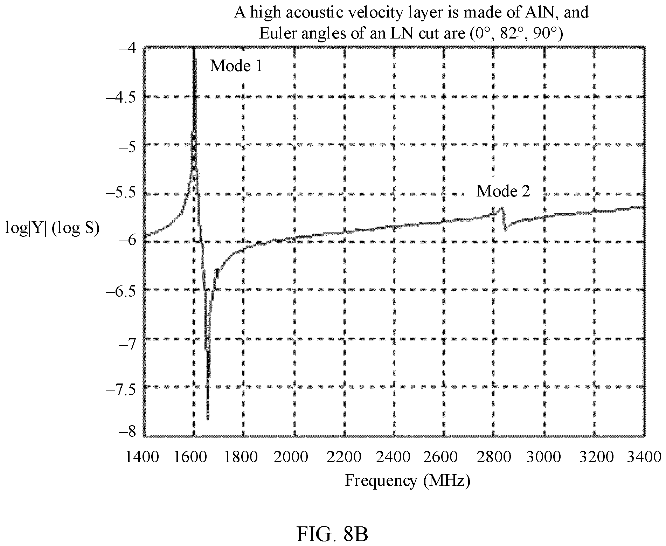

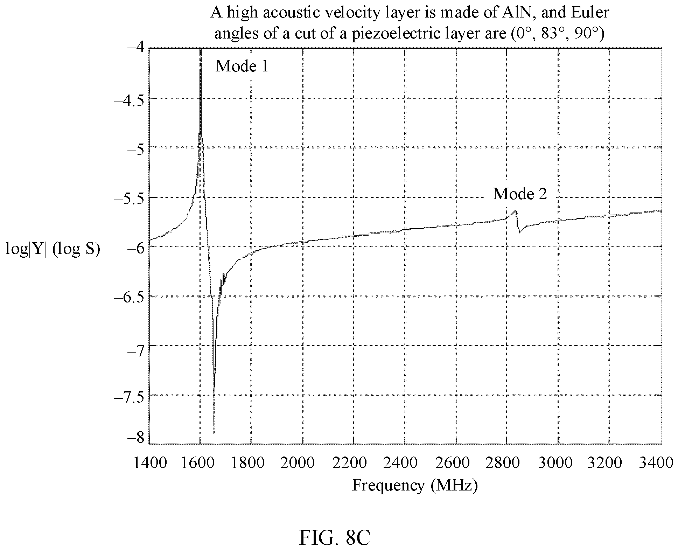

FIG. 8B and FIG. 8C are respectively admittance curve graphs of the surface acoustic wave filter with the structure shown in FIG. 6 when Euler angles of an LN cut are (0°, 82°, 90°) and (0°, 83°, 90°), where a frequency position and strength of an acoustic wave mode are similar to those shown in FIG. 8A. Therefore, the cuts of the piezoelectric layer provided in this embodiment of this application can significantly reduce out-of-band spurious modes of the surface acoustic wave filter.

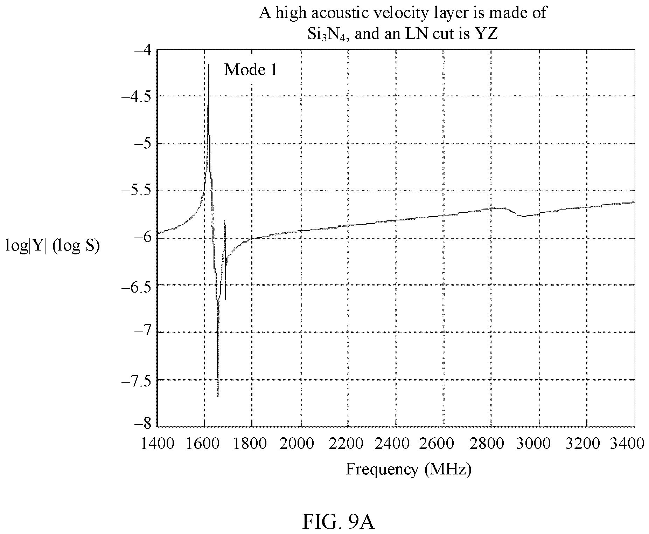

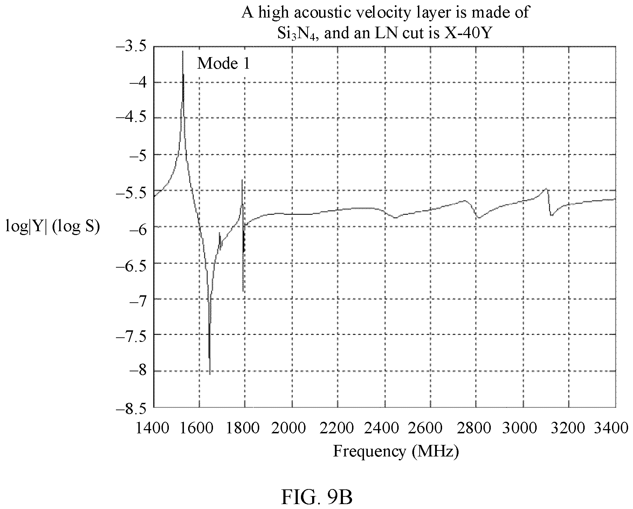

FIG. 7A to FIG. 8C correspond to simulation results obtained when a material of the high acoustic velocity layer 620 is AlN, and FIG. 9A to FIG. 10C are simulation results obtained when a material of the high acoustic velocity layer 620 is $Si_3N_4$. FIG. 9A and FIG. 9B are respectively admittance curve graphs when LN cuts are YZ and X-40Y. A thickness of $Si_3N_4$ is 50%$\lambda$, other structural parameters are the same as corresponding parameters of the surface acoustic wave filter in FIG. 7A and FIG. 7B.

As shown in FIG. 9A and FIG. 9B, when an LN cut is YZ or X-40Y, an obvious spurious mode exists at a location in an admittance curve that is higher than a frequency of the primary mode, that is, mode 1. For example, at a location whose frequency is about 1700 MHz in FIG. 9A, especially in the X-40Y cut, there are many spurious modes in a range of a used frequency band 2700 MHz, for example, 1700 MHz, 1790 MHz, and 2430 MHz, the device needs a complex spurious mode suppression means in practical use.

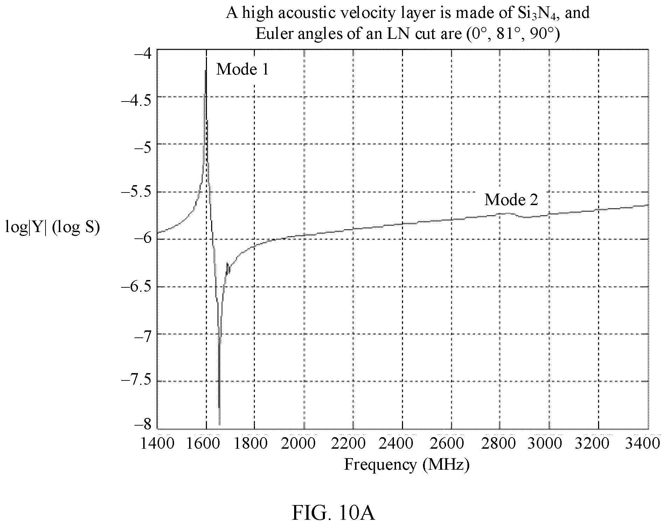

However, when Euler angles of an LN cut are (0°, 81°, 90°), as shown in FIG. 10A, on the operating frequency band, only tiny oscillations exist above an anti-resonance frequency of mode 1, and the tiny oscillations of mode 2 are significantly weakened when compared with those of mode 2 in the admittance curves shown in FIG. 8A to FIG. 8C. However, a frequency of mode 2 is greater than a used frequency band 2700 MHz, and therefore actual operation of the surface acoustic wave filter is not easily adversely affected. Therefore, the surface acoustic wave filter provided in this embodiment has no visible spurious mode on a practical frequency band, and actual operation of the device is not easily adversely affected.

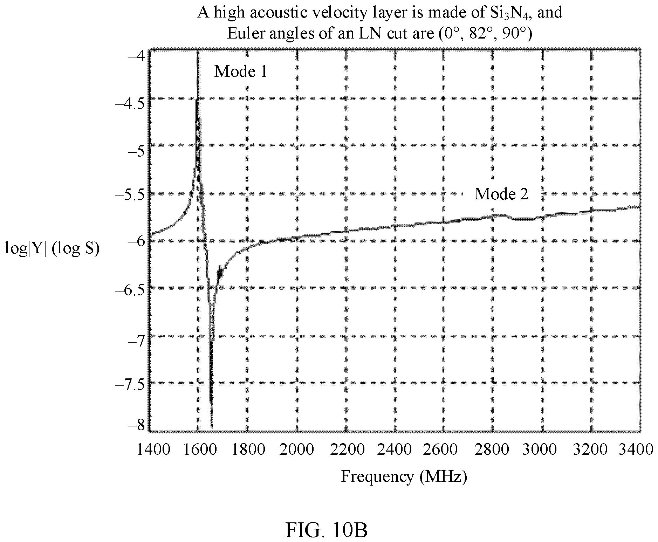

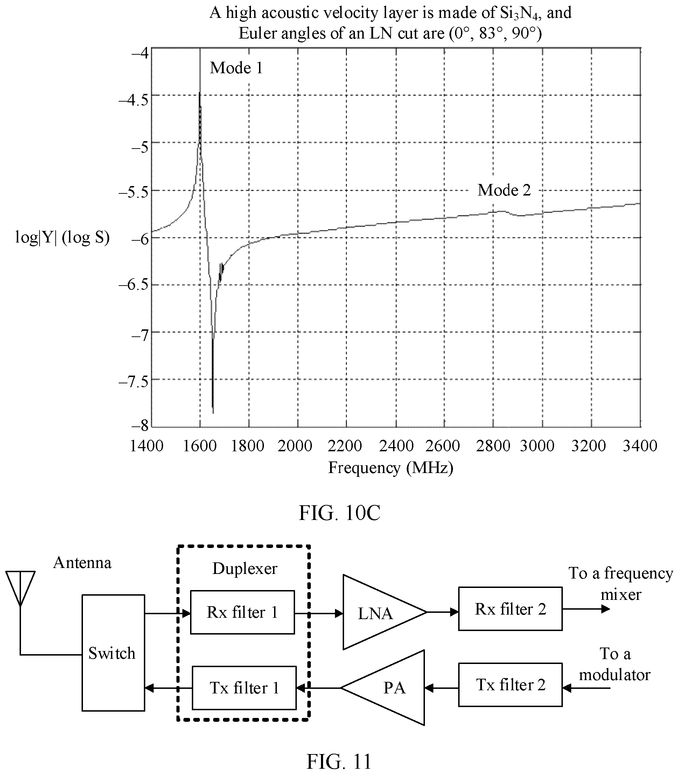

FIG. 10B and FIG. 10C are respectively admittance curve graphs when Euler angles of an LN cut are (0°, 82°, 90°) and (0°, 83°, 90°), where a frequency position and strength of an acoustic wave mode are similar to those shown in FIG.

10A. Therefore, the cuts of the piezoelectric layer provided in this embodiment of this application can significantly reduce out-of-band spurious modes of the surface acoustic wave filter.

Table 1 shows a comparison of surface energy ratios of the surface acoustic wave filter with or without a high acoustic velocity layer and a low acoustic velocity layer according to an embodiment of this application. A material of the interdigital electrode is Cu, and a thickness of the interdigital electrode is 5%$\lambda$; Euler angles of a cut of the piezoelectric layer are (0°, 82°, 90°), and a thickness of the piezoelectric layer is 20%$\lambda$; and a material of the support substrate is $Al_2O_3$, and a thickness of the support substrate is 500 $\mu$m to 1200 $\mu$m. It can be seen from Table 1 that when there is a high acoustic velocity layer but no low acoustic velocity layer, because the high acoustic velocity layer is formed above the support substrate, and the support substrate also has a high acoustic velocity, an acoustic velocity difference between the high acoustic velocity layer and the support substrate is small, and a capability of reflecting acoustic wave energy that is propagated vertically is insufficient. Consequently, energy of a surface acoustic wave leaks seriously, and a proportion of surface energy is only about 1%. However, when there is a low acoustic velocity layer but no high acoustic velocity layer, the low acoustic velocity layer is formed above the support substrate, and an acoustic velocity difference between the low acoustic velocity layer and the support substrate is large, so that acoustic wave energy that is propagated vertically can be reflected, so that an energy leakage problem is suppressed to some extent, and the proportion of surface energy reaches 96.47%. When there is a low acoustic velocity layer and a high acoustic velocity layer, there is a larger acoustic velocity difference between the low acoustic velocity layer and the high acoustic velocity layer, and reflection of acoustic wave energy is stronger. Therefore, a proportion of surface energy of the device is greater than 99%, and energy leakage is significantly suppressed.

**Table 1**

| Thickness of Cu | Thickness of LN | Thickness of $Al_2O_3$ | Thickness of $SiO_2$ | Thickness of AlN | Thickness of $Si_3N_4$ | Proportion of surface energy (%) |
|---|---|---|---|---|---|---|
| 5%$\lambda$ | 20%$\lambda$ | 500 $\mu$m to 1200 $\mu$m | 0 | 50%$\lambda$ | 0 | 1.42 |
| | | | 0 | 0 | 50%$\lambda$ | 0.88 |
| | | | 10%$\lambda$ | 0 | | 96.47 |
| | | | 10%$\lambda$ | 50%$\lambda$ | 0 | 99.43 |
| | | | 10%$\lambda$ | 0 | 50%$\lambda$ | 99.65 |

An embodiment of this application further provides a filter. The filter includes one or more surface acoustic wave filters, and at least one of the one or more surface acoustic wave filters has the structure of the surface acoustic wave filter shown in FIG. 2 or FIG. 6.

An embodiment of this application further provides a wireless communication device, which may be specifically a radio frequency front end of the wireless communication device. As shown in FIG. 11, the communication device includes two communication links: a receiving (Rx) link and a transmitting (Tx) link. On one hand, an antenna receives a weak Rx signal; an Rx filter #1, for example, a band pass filter (band pass filter, BPF), selects the weak Rx signal from a wide electromagnetic wave spectrum; the weak Rx signal is amplified by using a low noise amplifier (low noise amplifier, LNA); then the weak Rx signal passes through an Rx filter #2, for example, a BPF; and then the weak Rx signal is transmitted to a frequency mixer. On the other hand, a Tx signal transmitted from a modulator first passes through a Tx filter #2, for example, a BPF, to filter out a spectrum other than the Tx signal; then a to-be-transmitted Tx signal is amplified by using a power amplifier (power amplifier, PA); and then the Tx signal passes through a Tx filter #1, for example, a BPF, and is then transmitted through the same antenna.

At least one of the Rx filter #1, the Rx filter #2, the Tx filter #1, and the Tx filter #2 has a structure of the surface acoustic wave filter shown in FIG. 2 or FIG. 6.

An embodiment of this application further provides an apparatus. The apparatus may be specifically a chip module, including one or more surface acoustic wave filters. At least one of the one or more surface acoustic wave filters has a structure of the surface acoustic wave filter shown in FIG. 2 or FIG. 6. The chip module may further include at least one of the LNA, the PA, or the radio frequency switch shown in FIG. 11. The surface acoustic wave filter is coupled to at least one of the LNA, the PA, or the radio frequency switch.

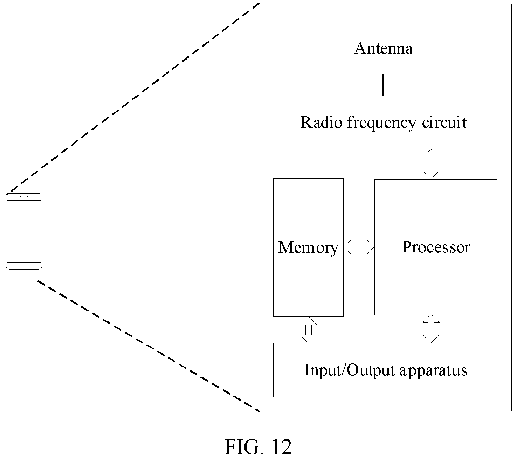

An embodiment of this application further provides an electronic device. As shown in FIG. 12, the electronic device includes a processor, a memory, a radio frequency circuit, an antenna, and an input/output apparatus. The processor is mainly configured to process a communication protocol and communication data, control the electronic device, execute a software program, process data of the software program, and the like. The memory is mainly configured to store the software program and data. The radio frequency circuit is mainly configured to: perform conversion between a baseband signal and a radio frequency signal, and process the radio frequency signal. The antenna is mainly configured to receive and send a radio frequency signal in a form of an electromagnetic wave. The input/output apparatus, such as a touchscreen, a display, or a keyboard, is mainly configured to: receive data input by a user and output data to the user. It should be noted that some types of electronic devices may have no input/output apparatus. In this application, the radio frequency circuit may include a plurality of filters, and at least one of the plurality of filters has a structure of the surface acoustic wave filter shown in FIG. 2 or FIG. 6.

When data needs to be sent, after performing baseband processing on the to-be-sent data, the processor outputs a baseband signal to the radio frequency circuit; and the radio frequency circuit performs radio frequency processing on the baseband signal and then sends the radio frequency signal to the outside in a form of an electromagnetic wave through the antenna. When data is sent to the electronic device, the radio frequency circuit receives the radio frequency signal through the antenna, converts the radio frequency signal into a baseband signal, and outputs the baseband signal to the processor. The processor converts the baseband signal into data, and processes the data. For ease of description, FIG. 12 shows only one memory and one processor. In an actual electronic device product, there may be one or more processors and one or more memories. The memory may also be referred to as a storage medium, a storage device, or the like. The memory may be deployed independent of the processor, or may be integrated with the processor. This is not limited in embodiments of this application.

In this embodiment of this application, the antenna and the radio frequency circuit that have a transceiver function may be considered as a transceiver unit of the electronic device, and the processor that has a processing function may be considered as a processing unit of the electronic device.

The electronic device may be a terminal device. The terminal device may also be referred to as user equipment (user equipment, UE), an access terminal, a subscriber unit, a subscriber station, a mobile station, a mobile console, a remote station, a remote terminal, a mobile device, a user terminal, a terminal, a wireless communication device, a user agent, or a user apparatus. The terminal device in embodiments of this application may be a mobile phone (mobile phone), a tablet (Pad), a computer having a wireless transceiver function, a virtual reality (virtual reality, VR) terminal device, an augmented reality (augmented reality, AR) terminal device, a wireless terminal in industrial control (industrial control), a wireless terminal in self-driving (self-driving), a wireless terminal in telemedicine (remote medical), a wireless terminal in a smart grid (smart grid), a wireless terminal in transportation safety (transportation safety), a wireless terminal in a smart city (smart city), a wireless terminal in a smart home (smart home), or the like. An application scenario is not limited in embodiments of this application.

It should be understood that FIG. 12 is illustrated only as an example. The electronic device may alternatively be a network device. The network device may be any device having a wireless transceiver function, and the device includes but is not limited to: an evolved node B (evolved node B, eNB), a radio network controller (radio network controller, RNC), a node B (node B, NB), a base station controller (base station controller, BSC), a base transceiver station (base transceiver station, BTS), a home base station (for example, home evolved Node B, or home Node B, HNB), or a base band unit (building base band unit, BBU); an access point (access point, AP), a wireless relay node, a wireless backhaul node, a transmission point (transmission point, TP), a transmission and reception point (transmission and reception point, TRP), or the like in a wireless fidelity (wireless fidelity, WiFi) system; a gNB or a transmission point (TRP or TP) in a 5G (for example, NR) system, one or a group (including a plurality of antenna panels) of antenna panels in the 5G system; or a network node constituting the gNB or the transmission point, such as a BBU or a distributed unit (distributed unit, DU), or the like.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A surface acoustic wave filter, comprising:

   a support substrate;
   a first acoustic velocity layer, wherein the first acoustic velocity layer is disposed on the support substrate, and a material of the first acoustic velocity layer is silicon dioxide;
   a piezoelectric layer, wherein the piezoelectric layer is disposed on the first acoustic velocity layer, Euler angles of a cut of the piezoelectric layer are (-5° to 5°, 81° to 83°, 85° to 95°), and a longitudinal wave acoustic velocity in the piezoelectric layer is higher than a longitudinal wave acoustic velocity in the first acoustic velocity layer; and
   an interdigital electrode, wherein the interdigital electrode is disposed above the piezoelectric layer.

2. The surface acoustic wave filter according to claim 1, wherein a material of the support substrate is silicon carbide or diamond.

3. The surface acoustic wave filter according to claim 1 or 2, wherein a material of the piezoelectric layer is lithium niobate.

4. The surface acoustic wave filter according to any one of claims 1 to 3, wherein a surface acoustic wave mode excited by the piezoelectric layer is a longitudinal leaky mode.

5. The surface acoustic wave filter according to any one of claims 1 to 4, wherein a thickness of the first acoustic velocity layer is 5%λ to 20%λ, and λ is a wavelength of the surface acoustic wave filter.

6. The surface acoustic wave filter according to any one of claims 1 to 5, wherein a thickness of the piezoelectric layer is 20%λ to 30%λ, and λ is the wavelength of the surface acoustic wave filter.

7. The surface acoustic wave filter according to any one of claims 1 to 6, wherein a material of the interdigital electrode is aluminum or copper.

8. The surface acoustic wave filter according to any one of claims 1 to 7, wherein a thickness of the interdigital electrode is 5%λ to 10%λ, and λ is the wavelength of the surface acoustic wave filter.

9. The surface acoustic wave filter according to any one of claims 1 to 8, wherein the wavelength of the surface acoustic wave filter is 1 μm to 4 μm.

10. A surface acoustic wave filter, comprising:

    a support substrate;
    a first acoustic velocity layer, wherein a material of the first acoustic velocity layer is silicon dioxide;
    a second acoustic velocity layer, wherein the second acoustic velocity layer is disposed between the support substrate and the first acoustic velocity layer, and a material of the second acoustic velocity layer is aluminum nitride or silicon nitride;
    a piezoelectric layer, wherein the piezoelectric layer is disposed on the first acoustic velocity layer, and Euler angles of a cut of the piezoelectric layer are (-5° to 5°, 81° to 83°, 85° to 95°); and
    an interdigital electrode, wherein the interdigital electrode is disposed above the piezoelectric layer, wherein a longitudinal wave acoustic velocity in the first acoustic velocity layer is lower than a longitudinal wave acoustic velocity in the piezoelectric layer, and a longitudinal wave acoustic velocity in the second acoustic velocity layer is higher than the longitudinal wave acoustic velocity in the piezoelectric layer.

11. The surface acoustic wave filter according to claim 10, wherein a material of the support substrate is aluminum oxide.

12. The surface acoustic wave filter according to claim 10 or 11, wherein a material of the piezoelectric layer is lithium niobate.

13. The surface acoustic wave filter according to any one of claims 10 to 12, wherein a surface acoustic wave mode excited by the piezoelectric layer is a longitudinal leaky mode.

14. The surface acoustic wave filter according to any one of claims 10 to 13, wherein a thickness of the second acoustic velocity layer is 30%λ to 50%λ, and λ is a wavelength of the surface acoustic wave filter.

15. The surface acoustic wave filter according to any one of claims 10 to 14, wherein a thickness of the first acoustic velocity layer is 5%λ to 20%λ, and λ is the wavelength of the surface acoustic wave filter.

16. The surface acoustic wave filter according to any one of claims 10 to 15, wherein a thickness of the piezoelectric layer is 20%λ to 30%λ, and λ is the wavelength of the surface acoustic wave filter.

17. The surface acoustic wave filter according to any one of claims 10 to 16, wherein a material of the interdigital electrode is aluminum or copper.

18. The surface acoustic wave filter according to any one of claims 10 to 17, wherein a thickness of the interdigital electrode is 5%λ to 10%λ, and λ is the wavelength of the surface acoustic wave filter.

**19.** The surface acoustic wave filter according to any one of claims 10 to 18, wherein the wavelength of the surface acoustic wave filter is 1 $\mu$m to 4 $\mu$m.

**20.** An apparatus, comprising the surface acoustic wave filter according to any one of claims 1 to 9 or the surface acoustic wave filter according to any one of claims 10 to 19, and at least one of the following elements: a radio frequency switch, an amplifier, and a duplexer, wherein
the surface acoustic wave filter is coupled to at least one of the radio frequency switch, the amplifier, and the duplexer.

**21.** An electronic device, comprising:

a transceiver, configured to receive or send a signal, wherein the transceiver comprises the surface acoustic wave filter according to any one of claims 1 to 9 or the surface acoustic wave filter according to any one of claims 10 to 19; and
a processor, configured to perform signal processing on the signal, wherein
the transceiver is coupled to the processor.

Interdigital
electrode

Piezoelectric
substrate

z

y

x

FIG. 1

240

230

220

210

z

y

FIG. 2

FIG. 3

FIG. 4A

A support substrate is made of 3C-SiC, and Euler angles of
an LN cut are (0°, 82°, 90°)

FIG. 4B

A support substrate is made of 3C-SiC, and Euler angles of
an LN cut are (0°, 83°, 90°)

FIG. 4C

A support substrate is made of 4H/6H-SiC, and Euler angles of
an LN cut are (0°, 82°, 90°)

FIG. 5

FIG. 6

A high acoustic velocity layer is made of AlN,
and an LN cut is YZ

FIG. 7A

A high acoustic velocity layer is made of
AlN, and an LN cut is X-40Y

FIG. 7B

A high acoustic velocity layer is made of AlN, and Euler
angles of a cut of a piezoelectric layer are (0°, 81°, 90°)

FIG. 8A

A high acoustic velocity layer is made of AlN, and
Euler angles of an LN cut are (0°, 82°, 90°)

FIG. 8B

A high acoustic velocity layer is made of AlN, and Euler angles of a cut of a piezoelectric layer are (0°, 83°, 90°)

FIG. 8C

A high acoustic velocity layer is made of
$Si_3N_4$, and an LN cut is YZ

Mode 1

log|Y| (log S)

Frequency (MHz)

FIG. 9A

A high acoustic velocity layer is made of
$Si_3N_4$, and an LN cut is X-40Y

FIG. 9B

A high acoustic velocity layer is made of $Si_3N_4$, and
Euler angles of an LN cut are (0°, 81°, 90°)

FIG. 10A

A high acoustic velocity layer is made of $Si_3N_4$, and
Euler angles of an LN cut are (0°, 82°, 90°)

FIG. 10B

A high acoustic velocity layer is made of $Si_3N_4$, and
Euler angles of an LN cut are (0°, 83°, 90°)

FIG. 10C

FIG. 11

FIG. 12

## INTERNATIONAL SEARCH REPORT

| International application No. |
|---|
| **PCT/CN2023/101384** |

**A. CLASSIFICATION OF SUBJECT MATTER**

H03H9/02(2006.01)i

According to International Patent Classification (IPC) or to both national classification and IPC

**B. FIELDS SEARCHED**

Minimum documentation searched (classification system followed by classification symbols)

IPC:H03H

Documentation searched other than minimum documentation to the extent that such documents are included in the fields searched

Electronic data base consulted during the international search (name of data base and, where practicable, search terms used)

CNABS, CNTXT, ENTXTC, ENTCT, DWPI, VEN, CNKI: 大, 低, 第二, 第一, 反射, 高, 漏, 欧拉, 声速, 小, 压电, acoustic, first, high, leak, low, piezoelectric, second, substrate

**C. DOCUMENTS CONSIDERED TO BE RELEVANT**

| Category* | Citation of document, with indication, where appropriate, of the relevant passages | Relevant to claim No. |
|---|---|---|
| X | CN 108631747 A (SHOULDER ELECTRONICS LTD.) 09 October 2018 (2018-10-09) description, paragraph [0022] to paragraph [0044] | 1-21 |
| A | CN 112737543 A (GUANGDONG GUANGNAXIN TECHNOLOGY CO., LTD.) 30 April 2021 (2021-04-30) entire document | 1-21 |
| A | CN 112653420 A (GUANGDONG GUANGNAXIN TECHNOLOGY CO., LTD.) 13 April 2021 (2021-04-13) entire document | 1-21 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **29 September 2023** | **07 October 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/101384**

| Patent document cited in search report | | | Publication date (day/month/year) | Patent family member(s) | Publication date (day/month/year) |
|---|---|---|---|---|---|
| CN | 108631747 | A | 09 October 2018 | None | |
| CN | 112737543 | A | 30 April 2021 | None | |
| CN | 112653420 | A | 13 April 2021 | None | |

Form PCT/ISA/210 (patent family annex) (July 2022)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210771296